# FASCICULE DE BREVET EUROPEEN

(11) **EP 0 756 297 B1**
(45) Date de publication et mention de la délivrance du brevet: **22.11.2000**
(21) Numéro de dépôt: 96401531.7
(22) Date de dépôt: 11.07.1996
(51) Int. Cl.: H01F 41/02, H01F 1/147, C21D 8/12

(54) **Tôle d'acier électrique revêtue utilisée dans la fabrication de circuits magnétiques**
Beschichtetes elektrisches Stahlblech zur Herstellung von Magnetkreisen
Coated electrical steel sheet for the fabrication of magnetic ciruits

(30) Priorité: 26.07.1995 FR 9509032
(43) Date de publication de la demande: 29.01.1997
(73) Titulaire: SOLLAC S.A., 92800 Puteaux (FR)
(72) Inventeur: Amelot, Pascal, 78600 - Maisons Laffitte (FR); Hernandez, Jacques, 48200 - Saint-Chely d'Apcher (FR); Bavay, Jean-Claude, 62330 - Isbergues (FR); Verdun, Jean, 92150 - Suresnes (FR); Eple, Stéphanie, 57310 - Guenange (FR)
(74) Mandataire: Ventavoli, Roger

(56) Documents cités:
- FR-A- 1 533 663
- GB-A- 2 132 418
- US-A- 4 762 753

## Description

La présente invention concerne une tôle d'acier électrique revêtue utilisée dans la fabrication de circuits magnétiques et ayant une découpabilité améliorée, la tôle contenant dans sa composition pondérale moins de 6,5% de silicium et moins de 3% d'aluminium.

Il existe des tôles d'acier électrique revêtues d'un isolant sur une ou deux de leurs faces. Ces tôles sont utilisées dans la fabrication notamment de circuits magnétiques, circuits composés d'un empilement d'éléments découpés dans la tôle et superposés pour former des noyaux de circuits électromagnétiques. Le revêtement assure une isolation électrique entre les différents éléments empilés pour réduire les courants de Foucault et les pertes magnétiques dans les noyaux des circuits.

Les revêtements isolants sont réalisés à partir de vernis classés d'après la norme ASTM A.345-90 en plusieurs catégories dont :
- les vernis de classe C3 qui correspondent à des vernis purement organiques, de type résines polyester, époxy, phénolique, acrylique, seules ou associées, assurant une bonne isolation électrique du revêtement et améliorant la découpabilité de la tôle qui en est revêtue en comparaison avec une tôle nue. L'amélioration de la découpabilité entraîne une augmentation de la durée de vie des outils de découpe des éléments de circuits. Ces vernis résistent aux températures normales de fonctionnement des équipements électriques.

D'une manière générale, les vernis de la classe C3 ont des tenues en température plus faibles que les vernis comportant une charge minérale. Ils sont généralement utilisés pour le revêtement de tôles de circuits magnétiques de petits moteurs et transformateurs, applications pour lesquelles on privilégie l'aptitude au découpage des tôles revêtues grâce à l'effet lubrifiant du vernis purement organique.

Les vernis de classe C3 sont utilisés quand le critère de sélection prend prioritairement en compte la découpabilité de la tôle.
- les vernis de classe C5 qui correspondent à des vernis constitués d'une ou de plusieurs résines organiques comportant un polymère inorganique, comme par exemple un polyphosphate ou une résine silicone, et contenant des charges minérales. Ils peuvent aussi contenir de l'acide phosphorique et ou de l'acide chromique, notamment en l'absence de polyphosphate. La tenue en température des revêtements réalisés à partir de vernis de la classe C5 et la soudabilité des tôles revêtues sont supérieures à celles des tôles revêtues à partir des vernis de classe C3 et C6 et la découpabilité des tôles est reconnue inférieure à la découpabilité des tôles revêtues à partir des vernis de classe C3.

Les vernis de classe C5 permettent un recuit du circuit magnétique assemblé visant à éliminer les contraintes internes générées par le découpage, contraintes qui nuisent aux performances magnétiques.

Les vernis de classe C5 sont utilisés lorsqu'après découpage des tôles revêtues et assemblage du circuit magnétique, il est réalisé un recuit d'élimination des contraintes internes générées par le découpage.

Les vernis de classe C5 assurent, contrairement aux vernis de classe C3 et C6, une isolation électrique résiduelle après un recuit d'élimination des contraintes effectué à une température supérieure à 700°C.
- les vernis de classe C6 qui ne sont pas définis par la norme ASTM A. 345-90, correspondent à des vernis constitués d'au moins une résine organique comme, par exemple, une résine acrylique et ou une résine phénolique associées à des charges minérales. Ces vernis ont une tenue en température supérieure à la tenue en température de vernis de la classe C3 citée ci-dessus et supportent des températures voisines de 420°C. La découpabilité des tôles comportant un revêtement réalisé à partir de ce type de vernis est moindre que celle comportant un revêtement réalisé à partir des vernis de la classe C3.

Les vernis de la classe C6 sont de préférence utilisés pour des tôles revêtues de circuits magnétiques de grosses machines tournantes, application pour laquelle on privilégie l'isolation électrique qui est renforcée à haute température par la présence de charges minérales, au détriment de la découpabilité, d'où une usure plus rapide des outils de découpe due à la présence des charges minérales.

En résumé, à chaque classe de vernis pour revêtement sont associées des propriétés spécifiques comme, par exemple, une meilleure découpabilité des tôles comportant des revêtements réalisés avec un vernis de classe C3, une meilleure soudabilité et tenue en température des tôles comportant un revêtement réalisé à partir d'un vernis de la classe C5, une meilleure isolation électrique et aptitude à la rétention d'huile de découpage des revêtements réalisés avec un vernis de classe C6.

Il n'est donc pas évident en tenant compte de ces critères, de parvenir à une solution pouvant assurer un compromis entre les différentes caractéristiques des revêtements réalisés avec les vernis cités.

Le but de l'invention est de proposer une tôle d'acier électrique revêtue utilisée dans la fabrication de circuits magnétiques et ayant une découpabilité améliorée.

L'invention a pour objet une tôle d'acier électrique revêtue utilisée dans la fabrication de circuits magnétiques et ayant une découpabilité améliorée, la tôle contenant dans sa composition pondérale moins de 6,5% de silicium et moins de 3% d'aluminium, caractérisée en ce qu'elle comporte un revêtement dit supérieur et un revêtement dit inférieur de compositions différentes, le revêtement supérieur étant réalisé à partir d'un vernis composé d'au moins une résine organique, le revêtement inférieur étant réalisé à partir d'un vernis composé d'au moins une résine organique contenant au moins une charge minérale éventuellement associé à au moins un polymère inorganique.

Les autres caractéristiques de l'invention sont :
- le vernis, pour la réalisation du revêtement supérieur et/ou inférieur, contient en outre au moins un accélérateur de durcissement notamment de la famille chimique des aminoplastes.
- le revêtement supérieur est réalisé à partir d'un vernis composé d'au moins une résine organique choisie parmi une résine polyester, une résine époxy, une résine phénolique, une résine acrylique.
- le revêtement supérieur est réalisé à partir d'un vernis composé d'une résine polyester associée à une résine époxy et d'un accélérateur de durcissement de la famille des aminoplastes.
- le revêtement supérieur est réalisé à partir d'un vernis contenant en outre un polymère inorganique et au moins une charge minérale.
- le revêtement supérieur est réalisé à partir d'un vernis contenant un polymère inorganique choisi parmi une résine silicone, un polyphosphate éventuellement associés à de l'acide phosphorique et ou de l'acide chromique.
- le revêtement inférieur est réalisé à partir d'un vernis composé d'au moins une résine acrylique associée à au moins une résine phénolique.
- au moins un revêtement contient au moins une charge minérale choisie parmi les sulfates, sulfures, silicates, carbonates, oxydes métalliques, le carbone.
- au moins un revêtement contient au moins une charge minérale choisie parmi le sulfate de baryum, le sulfure de zinc, le silicate d'aluminium, l'oxyde de titane.
- le revêtement inférieur est réalisé à partir d'au moins une résine acrylique associée à une résine phénolique contenant une charge minérale à base de sulfate de baryum et/ou de sulfure de zinc.
- le revêtement inférieur est réalisé à partir d'un vernis composé d'au moins une résine organique contenant au moins une charge minérale et au moins un polymère inorganique.
- le vernis pour la réalisation du revêtement inférieur contient au moins un polymère inorganique choisi parmi une résine silicone, un polyphosphate.
- le revêtement inférieur est réalisé à partir d'un vernis composé d'au moins une résine acrylique associée à au moins une résine époxy et d'un accélérateur de durcissement notamment de type aminoplaste, des polymères inorganiques et de l'acide phosphorique et ou de l'acide chromique.
- au moins une charge minérale est un pigment.
- l'invention concerne également un circuit magnétique réalisé par découpage de la tôle dont la composition pondérale chimique est la suivante : carbone inférieur à 0,010%, azote inférieur à 0,010%, silicium inférieur à 6,5%, aluminium inférieur à 3%, manganèse inférieur à 2%, phosphore inférieur à 0,25%, l'acier pouvant contenir, en outre, en éléments résiduels ou en addition, de l'étain, de l'antimoine, du cuivre, du chrome, du nickel, du bore, la tôle comportant un revêtement supérieur et un revêtement inférieur de compositions différentes selon l'invention.
- l'invention concerne également un circuit magnétique de contacteur électromagnétique réalisé par découpage de la tôle revêtue selon l'invention.
- la tôle du contacteur comporte un revêtement inférieur dont la charge minérale est, en masse, supérieure à 60%.

La description qui suit fera bien comprendre l'invention.

La tôle d'acier utilisée pour l'invention a la composition chimique pondérale suivante : carbone inférieur à 0,010%, azote inférieur à 0,010%, silicium inférieur ou égal à 6,5%, aluminium inférieur à 3%, manganèse inférieur à 2%, phosphore inférieur à 0,25%, et peut contenir, en éléments résiduels ou en addition, de l'étain, de l'antimoine, du cuivre, du chrome, du nickel, du bore.

L'invention concerne une tôle d'acier électrique revêtue utilisée dans la fabrication de circuits magnétiques et ayant une découpabilité améliorée, la tôle contenant dans sa composition pondérale moins de 6,5% de silicium et moins de 3% d'aluminium.

Selon l'invention, la tôle comporte un revêtement dit supérieur et un revêtement dit inférieur. En d'autres termes, la tôle comporte deux revêtements différents sur chacune de ses faces et, pour l'opération de découpe des éléments de circuits électriques, il est nécessaire de placer le revêtement dit supérieur en vis à vis du poinçon de l'outil de découpe ou encore, le revêtement dit inférieur en contact avec la matrice dudit outil de découpe.

En effet, il a été constaté, de manière surprenante, que le comportement de la tôle revêtue dans le domaine de la découpabilité est fonction du type de revêtement utilisé sur chacune des deux faces de la tôle et du sens de découpage par rapport au mouvement du poinçon de l'outil de coupe.

De plus, il a été constaté que l'association de deux revêtements différents dans le sens de découpage décrit ci dessus peut réduire de façon conséquente l'énergie dissipée par frottement sur le poinçon et la matrice, comparativement aux énergies dissipées par frottement dans le cas où la tôle comporte un même revêtement sur ses deux faces quel que soit le type de revêtement utilisé.

Les caractéristiques de la tôle électrique revêtue selon l'invention sont illustrées par les exemples suivants, l'aptitude à la découpabilité de la tôle étant évaluée à partir de l'énergie dissipée par frottement dans une opération de poinçonnage. Plus cette énergie est grande, plus l'usure de l'outil sera grande.

Les valeurs des énergies dissipées par frottement, données dans les exemples suivants correspondent à un outil de découpe constitué d'un poinçon ou perceur en carbure d'un diamètre de 50 mm et d'une matrice en carbure ayant un diamètre de 50,05 mm.

### Exemple 1

Une tôle d'acier électrique de 0,5 mm d'épaisseur contenant dans sa composition 0,002% de carbone, 0,004% d'azote, 0,34% de silicium, 0,35% de manganèse, 0,17% de phosphore et ayant subi un recuit final est revêtue pour des mesures comparatives, d'une part du même vernis sur chacune des deux faces, le vernis pouvant être celui utilisé pour le revêtement supérieur ou pour le revêtement inférieur et, d'autre part, selon l'invention, du vernis utilisé pour le revêtement supérieur sur la face de la tôle destinée à être placée en vis à vis du poinçon et du vernis utilisé pour le revêtement inférieur sur la face de la tôle destinée à être placée en vis à vis de la matrice de l'outil de découpe.

Le vernis destiné au revêtement supérieur est de 3 microns d'épaisseur et le vernis destiné au revêtement inférieur est de 3 microns d'épaisseur.

Le tableau 1 présente les énergies dissipées par frottement dans une opération de découpe sans lubrification pour une tôle non revêtue, pour une tôle comportant un revêtement sur deux faces réalisé à partir d'un vernis utilisé pour le revêtement supérieur, pour une tôle comportant un revêtement sur deux faces réalisé à partir d'un vernis utilisé pour le revêtement inférieur, pour une tôle revêtue sur chacune des faces avec un revêtement réalisé à partir de deux vernis différents, d'une part, selon l'invention, chacun utilisé respectivement pour le revêtement de la face supérieure de la tôle et de la face inférieure de ladite tôle et d'autre part, pour comparaison, chacun utilisé de manière inverse, c'est à dire le revêtement de la face supérieur en tant que revêtement de la face inférieure et vis versa.

Le vernis pour la réalisation du revêtement supérieur, de classe C3, est constitué d'une résine polyester associée à une résine époxy et d'un accélérateur de durcissement de la famille des aminoplastes. Il contient un agent anti rayure, les rayures pouvant être générées, lors du frottement, l'une contre l'autre, des spires de la bobine de tôle vernie.

Le vernis pour la réalisation du revêtement inférieur, de classe C6, est constitué d'une résine acrylique associée à une résine phénolique. Il contient en outre des charges minérales à base de sulfate de baryum et de sulfure de zinc, le pourcentage en masse des résines étant de 20% et celui des charges minérales de 80%.

**TABLEAU 1**

| | **Energie dissipée kJ.mm-1** |
|---|---|
| Tôle non revêtue | 894 |
| Tôle revêtue deux faces vernis supérieur C3 | 764 |
| Tôle revêtue deux faces vernis inférieur C6 | 823 |
| Tôle selon l'invention : vernis supérieur C3 vernis inférieur C6 | 538 |

L'examen des valeurs de l'énergie dissipée par frottement lors des opérations de découpe sans lubrification, présentées dans le tableau 1, montre l'effet bénéfique de la tôle selon l'invention. La combinaison sur chacune des faces de la tôle d'un revêtement dit supérieur et d'un revêtement dit inférieur, le revêtement supérieur étant composé de trois résines organiques et le revêtement inférieur étant composé de deux résines organiques associées à des charges minérales se traduit par une amélioration exceptionnelle de la découpabilité de la tôle, l'énergie dissipée par le frottement étant très inférieure à celle relative aux tôles revêtues sur deux faces d'un même vernis même réputé pour son excellente aptitude à la découpabilité.

La position du revêtement supérieur de type résines organiques exclusivement en vis à vis du poinçon de l'outil de coupe est une condition nécessaire à l'obtention de cette amélioration exceptionnelle de la découpabilité.

Ce phénomène est mis en évidence sur le tableau 2 ci dessous :

**TABLEAU 2**

| | **Energie dissipée kJ.mm-1** |
|---|---|
| Tôle selon l'invention revêtement supérieur C3 en vis à vis du poinçon | 538 |
| Tôle selon l'invention revêtement inférieur C6 en vis à vis du poinçon | 2 415 |

Les valeurs de l'énergie dissipée montrent une forte dégradation de la découpabilité lorsque la position de la tôle par rapport au poinçon et à la matrice n'est pas respectée.

### Exemple 2

Une tôle d'acier électrique de 0,5 mm d'épaisseur contenant dans sa composition 0,004% de carbone, 0,004% d'azote, 2,9% de silicium, 0,38% d'aluminium, 0,19% de manganèse, 0,018% de phosphore, et ayant subi un recuit final, est revêtue pour des mesures comparatives, d'une part du même vernis sur chacune des deux faces, le vernis pouvant être celui utilisé pour le revêtement supérieur ou le vernis utilisé pour le revêtement inférieur et, d'autre part, selon l'invention, du vernis utilisé pour le revêtement supérieur sur la face de la tôle destinée à être placée en vis à vis du poinçon et du vernis utilisé pour le revêtement inférieur sur la face de la tôle destinée à être placée en vis à vis de la matrice de l'outil de découpe.

Le vernis destiné au revêtement supérieur est de 3 ou 4 microns d'épaisseur et le vernis destiné au revêtement inférieur est de 3 ou 5 microns d'épaisseur. Les vernis utilisés sont ceux de l'exemple 1.

Le découpage de la tôle est effectué sans lubrification.

Les résultats de l'essai de l'exemple 2 sont résumés dans le tableau 3 suivant :

**TABLEAU 3**

| Epaisseur du vernis: 3 µm | |
|---|---|
| | **Energie dissipée kJ.mm-1** |
| Tôle non revêtue | 1 224 |
| Tôle revêtue deux faces vernis supérieur C3 | 1 258 |
| Tôle revêtue deux faces vernis inférieur C6 | 952 |
| Tôle selon l'invention : vernis supérieur C3 vernis inférieur C6 | 740 |

L'examen des valeurs de l'énergie dissipée lors des opérations de découpe, présentées dans le tableau 3, montre comme dans l'exemple 1, l'effet bénéfique de la tôle selon l'invention.

Dans un autre essai, il a été mis en évidence le rôle de la lubrification sur la même tôle d'acier que dans l'exemple 2.

Le lubrifiant utilisé dans cet exemple est un lubrifiant de référence commerciale P3 DULTAN 759 de HENKEL.

Le vernis destiné au revêtement supérieur est le vernis C3 de l'exemple 1 et possède une épaisseur de 4 microns et le vernis destiné au revêtement inférieur est le vernis C6 de l'exemple 1 et possède également une épaisseur de 4 microns.

**TABLEAU 4**

| Epaisseur du vernis: 4 µm | |
|---|---|
| | **Energie dissipée kJ.mm-1** |
| Tôle selon l'invention lubrifiée sur deux faces | 811 |
| Tôle selon l'invention lubrifiée sur face inférieure | 588 |

On peut constater, d'après le tableau 4, de manière surprenante, que la lubrification de la tôle selon l'invention réduit l'énergie de frottement dissipée en particulier, dans cet exemple, lorsque la lubrification est effectuée sur un seul revêtement et de préférence sur le revêtement inférieur, c'est-à-dire lorsque la tôle selon l'invention est lubrifiée du coté de la matrice de l'outil de découpage.

### Exemple 3

Une tôle d'acier électrique de 0,5 mm d'épaisseur contenant dans sa composition 0,002% de carbone, 0,004 d'azote, 0,34% de silicium, 0,35% de manganèse, 0,17% de phosphore et ayant subi un recuit final, est revêtue pour des mesures comparatives, d'une part, du même vernis sur chacune des deux faces, le vernis pouvant être celui utilisé pour le revêtement supérieur ou le vernis utilisé pour le revêtement inférieur et, d'autre part, selon l'invention, du vernis utilisé pour le revêtement supérieur sur la face de la tôle destinée à être placée en vis à vis du poinçon et du vernis utilisé pour le revêtement inférieur sur la face de la tôle destinée à être placée en vis à vis de la matrice de l'outil de découpe.

Dans cet exemple, le revêtement supérieur est celui réalisé avec le vernis de la classe C3 de l'exemple 1.

Le revêtement inférieur est réalisé à partir d'un vernis de la classe C5 qui est composé d'une résine acrylique associé à une résine époxy et d'un accélérateur de durcissement de type aminoplaste. Il contient en outre des charges de la famille des silicates d'aluminium, des polymères inorganiques de type polyphosphate et de l'acide phosphorique.

Le vernis destiné au revêtement supérieur est de 3 microns d'épaisseur et le vernis destiné au revêtement inférieur est de 1,5 micron d'épaisseur.

La découpe de la tôle est effectuée sans lubrification.

**TABLEAU 5**

| | **Energie dissipée KJ.mm-1** |
|---|---|
| Tôle non revêtue | 894 |
| Tôle revêtue deux faces vernis supérieur C3 | 764 |
| Tôle revêtue deux faces vernis inférieur C5 | 785 |
| Tôle selon l'invention: vernis supérieur C3, vernis inférieur C5 | 570 |

Nous constatons d'après le tableau 5, que l'effet de la réduction de l'énergie dissipée par frottement se manifeste également avec un revêtement dit inférieur appartenant aux vernis de la classe C5.

L'ensemble des valeurs de l'énergie dissipée par frottement relatives aux exemples ci-dessus montre que le fait de revêtir une tôle d'un revêtement de classe différente sur les deux faces conduit à un niveau de performance en découpabilité non prévisible.

L'obtention d'une bonne découpabilité nécessite que le revêtement supérieur réalisé avec un vernis de classe C3 soit placé en vis à vis du poinçon dans une opération de découpe, le revêtement inférieur placé en vis à vis de la matrice étant un vernis de classe C5 ou C6.

Lors de l'opération de découpage, les phénomènes qui se produisent au niveau de la matrice et du poinçon ne sont pas identiques. Il est donc possible d'optimiser le découpage en tenant compte de l'équilibre entre ces phénomènes. Créer un différentiel de propriétés physiques entre les deux faces de la tôle revêtue est selon l'invention, un moyen d'optimiser la découpabilité de la tôle. Les propriétés physico chimiques envisagées sont entre autres, la qualité du vernis, le coefficient de frottement à sec ou avec lubrifiants, le dureté de la tôle sans vernis, etc. Chacune des surfaces de la tôle revêtue doit posséder des propriétés précises. On peut alors comprendre que lorsqu'on inverse la position de la tôle par rapport au couple poinçon-matrice, les résultats diffèrent. On constate que les meilleurs caractéristiques de découpabilité peuvent être obtenues de manière classique en lubrifiant les deux faces de la tôle revêtue, et, selon l'invention, de manière surprenante et totalement inattendue en lubrifiant par exemple, une seule des deux faces, ou mieux parfois, en effectuant la découpe à sec.

La tôle faisant l'objet de l'invention est réalisée à partir d'un dispositif pour le revêtement de tôle comportant deux têtes d'enduction indépendantes.

Les épaisseurs des deux revêtements selon l'invention sont ajustées pour tenir compte des propriétés des vernis utilisés.

La cuisson des deux revêtements est réalisée en continu, par exemple, par chauffage induction ou infrarouge de la tôle revêtue. Dans ces modes de chauffage, c'est la tôle substrat qui est chauffée, la cuisson des revêtements ayant lieu par diffusion de la chaleur à partir de l'interface métal-revêtement vers la surface des revêtements. Les températures de cuisson des deux revêtements doivent être proches l'une de l'autre pour éviter, soit une sous cuisson, soit une dégradation thermique d'un revêtement par surchauffe d'un vernis par rapport à l'autre.

Les vernis de classe C6 sont utilisés dans la réalisation de contacteurs. La durée de vie des contacteurs est fortement augmentée par ces vernis qui assurent la lubrification des pôles de contacteur en fonctionnant grâce à l'huile de découpage résiduelle piégée par la rugosité superficielle et les charges minérales contenues dans les revêtements réalisés.

L'invention concerne également un circuit magnétique réalisé par découpage de la tôle obtenue par le procédé, et notamment un contacteur électromagnétique réalisé par découpage de la tôle dont la composition pondérale chimique est la suivante : carbone inférieur à 0,010%, azote inférieur à 0,010%, silicium inférieur à 6,5%, aluminium inférieur à 3%, manganèse inférieur à 2%, phosphore inférieur à 0,25%, l'acier pouvant contenir en outre, en éléments résiduels ou en addition, de l'étain, de l'antimoine, du cuivre, du chrome, du nickel, du bore, la tôle comportant un revêtement dit supérieur et un revêtement dit inférieur, le revêtement supérieur étant réalisé à partir d'un vernis composé d'au moins une résine organique le revêtement inférieur étant réalisé à partir d'un vernis composé d'au moins une résine organique contenant au moins une charge minérale éventuellement associé à au moins un polymère inorganique.

La tôle dont est composé le contacteur comporte un revêtement inférieur dont la charge minérale est, en masse, supérieure à 60%. C'est à dire que la charge minérale, pouvant contenir un ou des pigments minéraux, ou encore, pouvant être constituée essentiellement d'un ou de plusieurs pigments minéraux est, en masse, supérieure à 60%.

### Exemple 4

Une tôle d'acier électrique de 0,50 mm d'épaisseur contenant dans sa composition 0,002% de carbone, 0,004% d'azote, 0,34% de silicium, 0,35% de manganèse, 0,17% de phosphore et ayant subi un recuit final, est revêtue, pour des mesures comparatives, d'une part, du même vernis sur chacune des deux faces, le vernis pouvant être celui utilisé pour le revêtement supérieur ou pour le revêtement inférieur et, d'autre part, selon l'invention, du vernis utilisé pour le revêtement supérieur sur la face destinée à être placée en vis à vis de poinçon et du vernis utilisé pour le revêtement inférieur sur la face destinée à être placée en vis à vis de la matrice de l'outil de découpe.

Le vernis destiné au revêtement supérieur est un vernis de la classe C3, de même composition que dans l'exemple 1, dont l'épaisseur est de 3 microns.

Le vernis destiné au revêtement inférieur est un vernis de la classe C6, dont l'épaisseur est de 3 microns.

Le vernis de classe C6 est constitué d'une résine acrylique associée à une résine phénolique et à une résine de la famille des aminoplastes, le pourcentage en masse des résines étant de 27% et le pourcentage en masse des charges telles que BaSO₄ et ZnS étant de 73%.

Les résultats des mesures d'énergie dissipée par frottement sont présentés dans le tableau 6.

**TABLEAU 6**

| | **Energie dissipée kJ.mm**^{**-1**} |
|---|---|
| • Tôle selon l'invention non lubrifiée | 532 |
| • Tôle selon l'invention lubrifiée deux faces. | 307 |

On peut constater, d'après le tableau 6, que la lubrification améliore fortement la découpabilité de la tôle lorsque la tôle selon l'invention est, dans cet exemple, lubrifiée sur ses deux faces.

### Exemple 5

Une tôle d'acier électrique de 0,50 mm d'épaisseur contenant dans sa composition 0,004% de carbone, 0,004% d'azote, 2,9% de silicium, 0,38% d'aluminium, 0,19% de manganèse, 0,018% de phosphore, et ayant subi un recuit final, est revêtue, pour des mesures comparatives, d'une part du même vernis sur chacune des deux faces, le vernis pouvant être celui utilisé pour le revêtement supérieur ou le vernis utilisé pour le revêtement inférieur et, d'autre part, selon l'invention, du vernis utilisé pour le revêtement supérieur sur la face de la tôle destinée à être placée en vis-à-vis du poinçon et du vernis utilisé pour le revêtement inférieur sur la face de la tôle destinée à être placée en vis-à-vis de la matrice de l'outil de découpe.
Dans une forme de l'invention, le revêtement supérieur est réalisé à partir d'un vernis de classe C5 composé d'au moins une résine organique pouvant contenir, en outre, au moins un polymère inorganique et au moins une charge minérale, de l'acide phosphorique et ou de l'acide chromique.

Le vernis de classe C5 destiné au revêtement supérieur est de 1,5 micron d'épaisseur et de même composition que dans l'exemple 3 et le vernis de classe C6 destiné au revêtement inférieur est de 3 microns d'épaisseur et de même composition que dans l'exemple 1.

Les résultats des mesures d'énergie dissipée par frottement sont présentés dans le tableau 7.

**TABLEAU 7**

| | **Energie dissipée (kJ.mm**^{**-1**}**)** |
|---|---|
| • Tôle non revêtue deux faces non lubrifiée. | 1 224 |
| • Tôle revêtue deux faces vernis supérieur C5 non lubrifiées. | 857 |
| • Tôle revêtue deux faces vernis inférieur C6 non lubrifiées. | 952 |
| • Tôle selon l'invention non lubrifiée: vernis supérieur C5 et vernis inférieur C6. | 841 |
| • Tôle selon l'invention lubrifiée deux faces | 704 |

D'après le tableau 7, il apparaît que la tôle selon l'invention présente une meilleure découpabilité que la tôle revêtue sur les deux faces du même revêtement de classe C6 en l'absence de lubrification.

La lubrification des deux faces de la tôle selon l'invention permet une amélioration significative de l'aptitude à la découpabilité de la tôle selon l'invention, la face revêtue d'un vernis inférieur de classe C6 étant placée en vis-à-vis de la matrice de l'outil de découpe.

### Exemple 6

Les tôles d'acier à 0,34% et 2,9% de silicium des exemples 4 et 5, revêtues sur une face du vernis de classe C6 d'épaisseur 3 microns et sur l'autre face du vernis de classe C5 d'épaisseur 1,5 micron sont découpées, dans cet exemple de façon que, la face revêtue du vernis de classe C6 soit placée en vis-à-vis du poinçon de la matrice.

Les résultats des mesures d'énergie dissipée par frottement sont présentés dans le tableau 8.

**TABLEAU 8**

| | **Energie dissipée kJ.mm**^{**-1**} |
|---|---|
| • Tôle revêtue deux faces non lubrifiées : | |
| = > Acier à 0,34% de silicium | 1 903 |
| = > Acier à 2,9% de silicium | 1 314 |

La comparaison des résultats du tableau 8 et des résultats d'une part de l'exemple 7 suivant et de l'exemple 5 relatifs à la tôle selon l'invention montre que dans le cas d'une tôle revêtue sur une face d'un vernis de classe C5 et sur l'autre face d'un vernis de classe C6, il est impératif que la face revêtue du vernis de classe C5 soit placée en vis-à-vis du poinçon pour obtenir la meilleure aptitude à la découpe. Dans le cas contraire, il s'ensuit une forte dégradation de la découpabilité.

### Exemple 7

Une tôle d'acier électrique de 0,50 mm d'épaisseur contenant dans sa composition 0,002% de carbone, 0,004% d'azote, 0,34% de silicium, 0,35% de manganèse, 0,17% de phosphore et ayant subi un recuit final, est revêtue pour des mesures comparatives, d'une part du même vernis sur chacune des deux faces, le vernis pouvant être celui utilisé pour le revêtement supérieur ou le revêtement inférieur et, d'autre part, selon l'invention, du vernis utilisé pour le revêtement supérieur sur la face de la tôle destinée à être placée en vis-à-vis du poinçon et du vernis utilisé pour le revêtement inférieur sur la face de la tôle destinée à être placée en vis-à-vis de la matrice de l'outil de découpe.

Le vernis destiné au revêtement supérieur est un vernis de classe C5, de même composition que dans l'exemple 3, de 1,5 micron d'épaisseur.

Le vernis destiné au revêtement inférieur est un vernis de classe C6, de même composition que dans l'exemple 2, et de 3 microns d'épaisseur.

Les résultats des mesures d'énergie dissipée par frottement son présentés dans le tableau 9.

**TABLEAU 9**

| | **Energie dissipée kJ.mm**^{**-1**} |
|---|---|
| • Tôle non revêtue deux faces non lubrifiées | 894 |
| • Tôle non revêtue deux faces lubrifiées | 632 |
| • Tôle revêtue deux faces vernis supérieur C5 non lubrifiées | 785 |
| • Tôle revêtue deux faces vernis inférieur C6 non lubrifiées | 823 |
| • Tôle selon l'invention non lubrifiée :vernis supérieur C5, vernis inférieur C6 | 809 |
| • Tôle selon l'invention lubrifiée deux faces | 338 |

D'après le tableau 9, il apparaît que la lubrification des deux faces de la tôle selon l'invention réduit considérablement l'énergie dissipée par frottement et, en conséquence, améliore très fortement l'aptitude à la découpe de la tôle selon l'invention, la face revêtue d'un vernis inférieur de classe C6 étant placée en vis-à-vis de la matrice de l'outil de découpe.

On peut obtenir avec le couple [vernis supérieur de classe C5 / vernis inférieur de classe C6] la même aptitude à la découpabilité que le couple [vernis supérieur de classe C3 / vernis inférieur de classe C6] lorsque la tôle revêtue est lubrifiée sur les deux faces, les énergies dissipées par frottement étant pratiquement égales.

### Exemple 8

Une tôle d'acier électrique de 0,5 mm d'épaisseur contenant dans sa composition 0,004% de carbone, 0,004% d'azote, 2,9% de silicium, 0,38% d'aluminium, 0,19% de manganèse, 0,0018% de phosphore et ayant subi un recuit final, est revêtue, pour des mesures comparatives, d'une part du même vernis sur chacune des deux faces, le vernis pouvant être celui utilisé pour le revêtement supérieur ou pour le revêtement inférieur et, d'autre part, selon l'invention, du vernis utilisé pour le revêtement supérieur sur la face de la tôle destinée à être placée en vis-à-vis du poinçon et du vernis utilisé pour le revêtement inférieur sur la face destinée à être placée en vis-à-vis de la matrice de l'outil de découpe.

Le vernis destiné au revêtement supérieur est un vernis de classe C3, de même composition que dans l'exemple 1, et de 3 microns d'épaisseur.

Le vernis destiné au revêtement inférieur est un vernis de classe C6 et d'épaisseur 3 microns. Ce vernis de classe C6 est constitué d'une résine acrylique associée à une résine phénolique et à une résine de la famille des aminoplastes, le pourcentage en masse des résines étant de 27% et le pourcentage en masse des charges (BaSO₄ et ZnS) étant de 73%.

Les résultats des mesures d'énergie dissipée par frottement sont présentés dans le tableau 10.

**TABLEAU 10**

| | **Energie dissipée (kJ.mm**^{**-1)**} |
|---|---|
| ● Tôle revêtue deux faces vernis supérieur C3 non lubrifiées | 1 258 |
| ● Tôle revêtue deux faces vernis inférieur C6 non lubrifiées | 954 |
| ● Tôle revêtue deux faces vernis inférieur C6 lubrifiées | 762 |
| ● Tôle selon l'invention non lubrifiée: vernis supérieur C3, vernis inférieur C6 | 717 |
| ● Tôle selon l'invention lubrifiée deux faces | 665 |

### Exemple 9

Une tôle d'acier électrique de 0,50 mm d'épaisseur contenant dans sa composition 0,004% de carbone, 0,004% d'azote, 2,9% de silicium, 0,38% d'aluminium, 0,19% de manganèse, 0,018% de phosphore, et ayant subi un recuit final, est revêtue sur une face du vernis de classe C3 et sur l'autre face du vernis de classe C6, ces vernis ayant la même composition que dans l'exemple 1.

L'épaisseur des deux vernis est identique et égale à 3 ou 4 microns.

Les résultats des mesures d'énergie dissipée par frottement sont présentés dans le tableau 11.

**TABLEAU 11**

| | **Energie dissipée kJ.mm**^{**-1**} |
|---|---|
| **Epaisseur des vernis : 4 microns** | |
| * Face revêtue du vernis C3 placée en vis-à-vis du poinçon de la matrice, sans lubrification. | 699 |
| * Face revêtue du vernis C6 placée en vis-à-vis du poinçon de la matrice, avec lubrification deux faces. | 1 320 |
| **Epaisseur des vernis : 3 microns** | |
| * Face revêtue du vernis C6 placée en vis-à-vis du poinçon de la matrice, sans lubrification. | 1 522 |

La comparaison des résultats du tableau 11 montre que, pour obtenir la meilleure découpabilité, la face revêtue du vernis de classe C3 de la tôle selon l'invention, l'autre face étant revêtue d'un vernis de classe C6, doit être placée en vis-à-vis du poinçon. Dans le cas contraire, la découpabilité est fortement dégradée, malgré lubrification.

### Exemple 10

La découpe de la tôle selon l'invention de l'exemple 3 est effectuée avec lubrification des deux faces.

L'énergie dissipée par frottement est de 359 kJ.mm⁻¹ alors que l'énergie dissipée sans lubrification est de 570 kJ.mm⁻¹.

La diminution de l'énergie dissipée par frottement illustre l'effet bénéfique de la lubrification sur l'usure des outils dans cet exemple.

### Exemple 11

Une tôle d'acier électrique de 0,65 mm d'épaisseur contenant dans sa composition 0,004% de carbone, 0,005% d'azote, 3,2% de silicium, 0,80% d'aluminium, 0,12% de manganèse, 0,007% de phosphore et ayant subi un recuit final, est revêtue, pour des mesures comparatives, d'une part du même vernis de classe C6 sur chacune des deux faces et, d'autre part, selon l'invention, d'un vernis de classe C3 utilisé pour le revêtement supérieur sur la face de la tôle destinée à être placée en vis-à-vis du poinçon et d'un vernis de classe C6 utilisé pour le revêtement inférieur sur la face de la tôle destinée à être placée en vis-à-vis de la matrice de l'outil de découpe.

Dans cet exemple, le revêtement supérieur est celui réalisé avec le vernis de classe C3 de l'exemple 1. Le revêtement inférieur est celui réalisé avec le vernis de classe C6 de l'exemple 1.

La découpe de la tôle est effectuée sans lubrification.

Les résultats des mesures d'énergie dissipée par frottement en fonction de l'épaisseur des revêtements et de leur position vis-à-vis du poinçon sont présentés dans le tableau 12.

**TABLEAU 12**

| | **Energie dissipée kJ.mm**^{**-1**} |
|---|---|
| • Tôle non revêtue | 1 912 |
| • Tôle revêtue deux faces vernis de classe C6 d'épaisseur 5 µ | 1 672 |
| • Tôle selon l'invention : | |
| * revêtement supérieur de classe C3 d'épaisseur 3 µ, revêtement inférieur de classe C6 d'épaisseur 3 µ | 1 389 |
| * revêtement supérieur de classe C3 d'épaisseur 3 µ, revêtement inférieur de classe C6 d'épaisseur 4 µ | 1 007 |
| * revêtement supérieur de classe C3 d'épaisseur 3 µ, revêtement inférieur de classe C6 d'épaisseur 5 µ | 1 205 |
| * revêtement supérieur de classe C3 d'épaisseur 4 µ, revêtement inférieur de classe C6 d'épaisseur 3 µ | 1 415 |
| * revêtement supérieur de classe C3 d'épaisseur 4 µ, revêtement inférieur de classe C6 d'épaisseur 4 µ | 935 |
| * revêtement supérieur de classe C3 d'épaisseur 4 µ, revêtement inférieur de classe C6 d'épaisseur 5 µ | 1 223 |

Selon l'invention, l'obtention d'une meilleure découpabilité est obtenue en remplaçant le revêtement deux faces d'une tôle réalisé à partir d'un seul vernis, de classe C3 ou C5 ou C6, par une tôle revêtue sur une face par un vernis de classe C3 ou C5 et sur l'autre face par un vernis de classe C5 ou C6, les deux vernis étant toujours de classe différente.

L'obtention d'une bonne découpabilité nécessite, selon l'invention, que le revêtement dit supérieur réalisé avec un vernis de classe C3 ou C5 soit placé en vis-à-vis du poinçon dans une opération de découpe, le revêtement dit inférieur étant placé en vis-à-vis de la matrice.

Lorsque le revêtement supérieur est constitué d'un vernis de classe C3, le revêtement inférieur peut être constitué d'un vernis de classe C5 ou C6.

Lorsque le revêtement supérieur est constitué d'un vernis de classe C5, le revêtement inférieur est constitué d'un vernis de classe C6.

La tôle faisant l'objet de l'invention est réalisée à partir d'un dispositif pour le revêtement de la tôle comportant deux têtes d'induction indépendantes.

Les épaisseurs des deux revêtements selon l'invention sont ajustées pour tenir compte des autres propriétés des vernis utilisés.

On constate que les meilleures caractéristiques de découpabilité peuvent être obtenues de manière classique en lubrifiant les deux faces de la tôle revêtue, et, selon l'invention, de manière surprenante et totalement inattendue en lubrifiant par exemple, une seule des deux faces, ou mieux parfois, en effectuant la découpe à sec.

## Revendications

1. Tôle d'acier électrique revêtue utilisée dans la fabrication de circuits magnétiques et ayant une découpabilité améliorée, la tôle contenant dans sa composition pondérale moins de 6,5% de silicium et moins de 3% d'aluminium, caractérisée en ce qu'elle comporte un revêtement dit supérieur et un revêtement dit inférieur de compositions différentes, le revêtement supérieur étant réalisé à partir d'un vernis composé d'au moins une résine organique, le revêtement inférieur étant réalisé à partir d'un vernis composé d'au moins une résine organique contenant au moins une charge minérale éventuellement associé à au moins un polymère inorganique.

2. Tôle d'acier électrique selon la revendication 1, caractérisée en ce que le vernis, pour la réalisation du revêtement supérieur et/ou inférieur, contient en outre au moins un accélérateur de durcissement de la famille chimique des aminoplastes.

3. Tôle d'acier électrique selon l'une des revendications 1 et 2, caractérisée en ce que le revêtement supérieur est réalisé à partir d'un vernis composé d'au moins une résine organique choisie parmi une résine polyester, une résine époxy, une résine phénolique, une résine acrylique.

4. Tôle d'acier électrique selon l'une des revendications 1 à 3, caractérisée en ce que le revêtement supérieur est réalisé à partir d'un vernis composé d'une résine polyester associée à une résine époxy et d'un accélérateur de durcissement de la famille des aminoplastes.

5. Tôle d'acier électrique selon l'une des revendications 1 à 4, caractérisée en ce que le revêtement supérieur est réalisé à partir d'un vernis contenant en outre un polymère inorganique et au moins une charge minérale.

6. Tôle d'acier électrique selon l'une des revendications 1 à 5, caractérisée en ce que le revêtement supérieur est réalisé à partir d'un vernis contenant un polymère inorganique choisi parmi une résine silicone, un polyphosphate éventuellement associés à de l'acide phosphorique et ou de l'acide chromique.

7. Tôle d'acier électrique selon l'une des revendications 1 à 6, caractérisée en ce que le revêtement inférieur est réalisé à partir d'un vernis composé d'au moins une résine acrylique associée à au moins une résine phénolique.

8. Tôle d'acier électrique selon l'une des revendications 1 à 7, caractérisée en ce qu'au moins un revêtement contient au moins une charge minérale choisie parmi les sulfates, sulfures, silicates, carbonates, oxydes métalliques, le carbone.

9. Tôle d'acier électrique selon l'une des revendications 1 à 8, caractérisée en ce qu'au moins un revêtement contient au moins une charge minérale choisie parmi le sulfate de baryum, le sulfure de zinc, le silicate d'aluminium, l'oxyde de titane.

10. Tôle d'acier électrique selon l'une des revendications 1 à 9, caractérisée en ce que le revêtement inférieur est réalisé à partir d'au moins une résine acrylique associée à une résine phénolique et contenant une charge minérale à base de sulfate de baryum et ou de sulfure de zinc.

11. Tôle d'acier électrique selon l'une des revendications 1 à 4, caractérisée en ce que le revêtement inférieur est réalisé à partir d'un vernis composé d'au moins une résine organique contenant au moins une charge minérale et au moins un polymère inorganique.

12. Tôle d'acier électrique selon l'une des revendications 1 à 4 et 11, caractérisée en ce que le vernis pour la réalisation du revêtement inférieur contient au moins un polymère inorganique choisi parmi une résine silicone, un polyphosphate.

13. Tôle d'acier électrique selon l'une des revendications 1 à 4 et 11 et 12, caractérisée en ce que le revêtement inférieur est réalisé à partir d'un vernis composé d'au moins une résine acrylique associée à au moins une résine époxy et d'un accélérateur de durcissement de type aminoplaste, des polymères inorganiques et de l'acide phosphorique.

14. Tôle d'acier électrique selon l'une des revendications 1 à 13 caractérisée en ce que au moins une charge minérale est un pigment.

15. Circuit magnétique réalisé par découpage de la tôle d'acier électrique revêtue selon l'une des revendications 1 à 14, caractérisé en ce que la tôle contient dans sa composition pondérale moins de 0,010% de carbone, moins de 0,010% d'azote, moins de 2% de manganèse, moins de 0,25% de phosphore, l'acier pouvant contenir en outre, en éléments résiduels ou en addition, de l'étain, de l'antimoine, du cuivre, du chrome, du nickel, du bore.

16. Circuit magnétique selon la revendication 15, caractérisé en ce que le circuit magnétique est un circuit magnétique de contacteur électromagnétique.

17. Circuit magnétique selon la revendication 16, caractérisé en ce que la tôle dont il est composé, comporte un revêtement inférieur dont la charge minérale est, en masse, supérieure à 60%.

18. Circuit magnétique selon l'une des revendications 15 à 17 caractérisée en ce que au moins une charge minérale est un pigment.

## Patentansprüche

1. Beschichtetes Elektroblech aus Stahl zur Verwendung bei der Herstellung von magnetischen Kreisen, mit einer verbesserten Stanzbarkeit, wobei das Blech in seiner Gewichtszusammensetzung weniger als 6,5% Silizium und weniger als 3% Aluminium aufweist, dadurch gekennzeichnet, dass es eine so genannte obere Beschichtung und eine so genannte untere Beschichtung unterschiedlicher Zusammensetzungen aufweist, wobei die obere Beschichtung hergestellt wird ausgehend von einem Lack, der zusammengesetzt ist aus wenigstens einem organischen Harz, während die untere Beschichtung hergestellt wird ausgehend von einem Lack, der zusammengesetzt ist aus wenigstens einem organischen Harz, das wenigstens einen mineralischen Zusatz enthält, gegebenenfalls zusammen mit wenigstens einem anorganischen Polymer.

2. Elektroblech aus Stahl nach Anspruch 1, dadurch gekennzeichnet, dass der Lack zur Herstellung der oberen und/oder unteren Beschichtung außerdem wenigstens einen Härtungsbeschleuniger aus der chemischen Gruppe der Aminoplaste enthält.

3. Elektroblech aus Stahl nach einem der Ansprüche 1 und 2, dadurch gekennzeichnet, dass die obere Beschichtung hergestellt wird ausgehend von einem Lack der zusammengesetzt ist aus wenigstens einem organischen Harz, das ausgewählt ist aus einem Polyesterharz, einem Epoxyharz, einem Phenolharz, einem Acrylharz.

4. Elektroblech aus Stahl nach einem der Ansprüche 1 bis 3, dadurch gekennzeichnet, dass die obere Beschichtung hergestellt ist ausgehend von einem Lack, der zusammengesetzt ist aus einem Polyesterharz zusammen mit einem Epoxyharz und einem Härtungsbeschleuniger aus der Gruppe der Aminoplaste.

5. Elektroblech aus Stahl nach einem der Ansprüche 1 bis 4, dadurch gekennzeichnet, dass die obere Beschichtung hergestellt ist ausgehend von einem Lack, der außerdem ein anorganisches Polymer und wenigstens einen mineralischen Zusatz enthält.

6. Elektroblech aus Stahl nach einem der Ansprüche 1 bis 5, dadurch gekennzeichnet, dass die obere Beschichtung hergestellt ist ausgehend von einem Lack, der ein anorganisches Polymer enthält, das ausgewählt ist aus einem Silikonharz, einem Polyphosphat, gegebenenfalls zusammen mit Phosphorsäure und/oder Chromsäure.

7. Elektroblech aus Stahl nach einem der Ansprüche 1 bis 6, dadurch gekennzeichnet, dass die untere Beschichtung hergestellt ist ausgehend von einem Lack, der zusammengesetzt ist aus wenigstens einem Acrylharz zusammen mit wenigstens einem Phenolharz.

8. Elektroblech aus Stahl nach einem der Ansprüche 1 bis 7, dadurch gekennzeichnet, dass wenigstens eine Beschichtung wenigstens einen mineralischen Zusatz enthält, der ausgewählt ist aus den Sulfaten, Sulfiden, Silikaten, Karbonaten, Metalloxyden, Kohlenstoff.

9. Elektroblech aus Stahl nach einem der Ansprüche 1 bis 8, dadurch gekennzeichnet, dass wenigstens eine Beschichtung wenigstens einen mineralischen Zusatz aufweist, der ausgewählt ist aus Bariumsulfat, Zinksulfid, Aluminiumsilikat, Titanoxid.

10. Elektroblech aus Stahl nach einem der Ansprüche 1 bis 9, dadurch gekennzeichnet, dass die untere Beschichtung hergestellt ist ausgehend von wenigstens einem Acrylharz zusammen mit einem Phenolharz, wobei sie einen mineralischen Zusatz auf Basis von Bariumsulfat und/oder Zinksulfid aufweist.

11. Elektroblech aus Stahl nach einem der Ansprüche 1 bis 4, dadurch gekennzeichnet, dass die untere Beschichtung hergestellt ist ausgehend von einem Lack, der zusammengesetzt ist aus wenigstens einem organischen Harz, das wenigstens einen mineralischen Zusatz und wenigstens ein anorganisches Polymer enthält.

12. Elektroblech aus Stahl nach einem der Ansprüche 1 bis 4 und 11, dadurch gekennzeichnet, dass der Lack zur Herstellung der unteren Beschichtung wenigstens ein anorganisches Polymer enthält, das ausgewählt ist aus einem Silikonharz, einem Polyphosphat.

13. Elektroblech aus Stahl nach einem der Ansprüche 1 bis 4 und 11 und 12, dadurch gekennzeichnet, dass die untere Beschichtung hergestellt ist ausgehend von einem Lack, der zusammengesetzt ist aus wenigstens einem Acrylharz zusammen mit wenigstens einem Epoxyharz und einem Härtungsbeschleuniger aus der Gruppe der Aminoplaste, anorganischen Polymeren und Phosphorsäure.

14. Elektroblech aus Stahl nach einem der Ansprüche 1 bis 13, dadurch gekennzeichnet, dass wenigstens ein mineralischer Zusatz ein Pigment ist.

15. Magnetischer Kreis hergestellt durch Stanzen des beschichteten Elektroblechs aus Stahl nach einem der Ansprüche 1 bis 14, dadurch gekennzeichnet, dass das Blech in seiner Gewichtszusammensetzung weniger als 0,010% Kohlenstoff, weniger als 0,010% Stickstoff, weniger als 2% Mangan und weniger als 0,25% Phosphor enthält, wobei der Stahl außerdem als Restelemente oder als Zusatz Zinn, Antimon, Kupfer, Chrom, Nickel, Bor enthalten kann.

16. Magnetischer Kreis nach Anspruch 15, dadurch gekennzeichnet, dass der magnetische Kreis ein magnetischer Kreis eines elektromagnetischen Schalters ist.

17. Magnetischer Kreis nach Anspruch 16, dadurch gekennzeichnet, dass das Blech, aus dem er besteht, eine untere Beschichtung aufweist, deren mineralischer Zusatz als Masse mehr als 60% beträgt.

18. Magnetischer Kreis nach einem der Ansprüche 15 bis 17, dadurch gekennzeichnet, dass wenigstens ein mineralischer Zusatz ein Pigment ist.

## Claims

1. Coated electrical steel lamination used in the manufacture of magnetic circuits and having an improved cutability, the lamination containing in its composition by weight less than 6.5% silicon and less than 3% aluminium, characterized in that it has a so-called upper coating and a so-called lower coating of different compositions, the upper coating being made from a varnish composed of at least one organic resin and the lower coating being made from a varnish composed of at least one organic resin containing at least one mineral filler optionally combined with at least one inorganic polymer.

2. Electrical steel lamination according to Claim 1, characterized in that the varnish for producing the upper and/or lower coating furthermore contains at least one cure accelerator of the chemical family of aminoplasts.

3. Electrical steel lamination according to either of Claims 1 and 2, characterized in that the upper coating is made from a varnish composed of at least one organic resin chosen from a polyester resin, an epoxy resin, a phenolic resin and an acrylic resin.

4. Electrical steel lamination according to one of Claims 1 to 3, characterized in that the upper coating is made from a varnish composed of a polyester resin combined with an epoxy resin and of a cure accelerator of the family of aminoplasts.

5. Electrical steel lamination according to one of Claims 1 to 4, characterized in that the upper coating is made from a varnish furthermore containing an inorganic polymer and at least one mineral filler.

6. Electrical steel lamination according to one of Claims 1 to 5, characterized in that the upper coating is made from a varnish containing an inorganic polymer chosen from a silicon resin and a polyphosphate, these optionally being combined with phosphoric acid and/or chromic acid.

7. Electrical steel lamination according to one of Claims 1 to 6, characterized in that the lower coating is made from a varnish composed of at least one acrylic resin combined with at least one phenolic resin.

8. Electrical steel lamination according to one of Claims 1 to 7, characterized in that at least one coating contains at least one mineral filler chosen from sulphates, sulphides, silicates, carbonates, metal oxides and carbon.

9. Electrical steel lamination according to one of Claims 1 to 8, characterized in that at least one coating contains at least one mineral filler chosen from barium sulphate, zinc sulphide, aluminium silicate and titanium oxide.

10. Electrical steel lamination according to one of Claims 1 to 9, characterized in that the lower coating is made from at least one acrylic resin combined with a phenolic resin and containing a mineral filler based on barium sulphate and/or on zinc sulphide.

11. Electrical steel lamination according to one of Claims 1 to 4, characterized in that the lower coating is made from a varnish composed of at least one organic resin containing at least one mineral filler and at least one inorganic polymer.

12. Electrical steel lamination according to one of Claims 1 to 4 and 11, characterized in that the varnish for producing the lower coating contains at least one inorganic polymer chosen from a silicon resin and a polyphosphate.

13. Electrical steel lamination according to one of Claims 1 to 4 and 11 and 12, characterized in that the lower coating is made from a varnish composed of at least one acrylic resin combined with at least one epoxy resin and of a cure accelerator of the aminoplast type, inorganic polymers and phosphoric acid.

14. Electrical steel lamination according to one of Claims 1 to 13, characterized in that at least one mineral filler is a pigment.

15. Magnetic circuit produced by cutting the coated electrical steel lamination according to one of Claims 1 to 14, characterized in that the lamination contains in its composition by weight less than 0.010% carbon, less than 0.010% nitrogen, less than 2% manganese and less than 0.25% phosphorus, the steel furthermore possibly containing, in terms of residual elements or additional elements, tin, antimony, copper, chromium, nickel or boron.

16. Magnetic circuit according to Claim 15, characterized in that the magnetic circuit is a magnetic circuit of an electromagnetic contactor.

17. Magnetic circuit according to Claim 16, characterized in that the lamination of which it is composed has a lower coating whose mineral filler is, by mass, greater than 60%.

18. Magnetic circuit according to one of Claims 15 to 17, characterized in that at least one mineral filler is a pigment.
